# NEW EUROPEAN PATENT SPECIFICATION

(11) **EP 2 461 026 B2**
(45) Date of publication and mention of the opposition decision: **21.12.2016**
(45) Mention of the grant of the patent: 27.03.2013
(21) Application number: 10193663.1
(22) Date of filing: 03.12.2010
(51) Int. Cl.: F03D 9/00, G01R 27/16, H02J 3/24, H02P 9/00, G01R 31/34

(54) **Arrangement and method for testing an electric power generation system**
Anordnung und Verfahren zum Prüfen eines Stromerzeugungssystems
Agencement et procédé de test d'un système de génération d'alimentation électrique

(43) Date of publication of application: 06.06.2012
(73) Proprietor: Siemens Aktiengesellschaft, 80333 München (DE)
(72) Inventor: Dreyer, Thomas, 28832 Achim (DE); Wulff, Steffen, 28217 Bremen (DE)

(56) References cited:
- EP-A2- 1 796 259
- WO-A1-03/058789
- ALEPUZ ET AL: "Interfacing Renewable Energy Sources to the Utility Grid Using a Three-Level Inverter", IEEE TRANSACTIONS ON INDUSTRIAL ELECTRONICS, IEEE SERVICE CENTER, PISCATAWAY, NJ, USA, vol. 53, no. 5, 1 October 2006 (2006-10-01), pages 1504-1511, XP011149353, ISSN: 0278-0046, DOI: DOI:10.1109/TIE.2006.882021
- SEMAN S ET AL: "Low voltage ride-through analysis of 2 MW DFIG wind turbine - grid code compliance validations", POWER AND ENERGY SOCIETY GENERAL MEETING - CONVERSION AND DELIVERY OF ELECTRICAL ENERGY IN THE 21ST CENTURY, 2008 IEEE, IEEE, PISCATAWAY, NJ, USA, 20 July 2008 (2008-07-20), pages 1-6, XP031304475, ISBN: 978-1-4244-1905-0

## Description

### Field of invention

The present invention relates to an arrangement and to a method for testing an electric power generation system, in particular a wind turbine system, to be connected to an utility grid having a predetermined first electrical impedance. In particular, the present invention relates to an arrangement and to a method for testing the electric power generation system, wherein the arrangement and the method are adapted to test the electric power generation system at a test site remote from a production site at which the electric power generation system eventually is supposed to be installed.

### Art Background

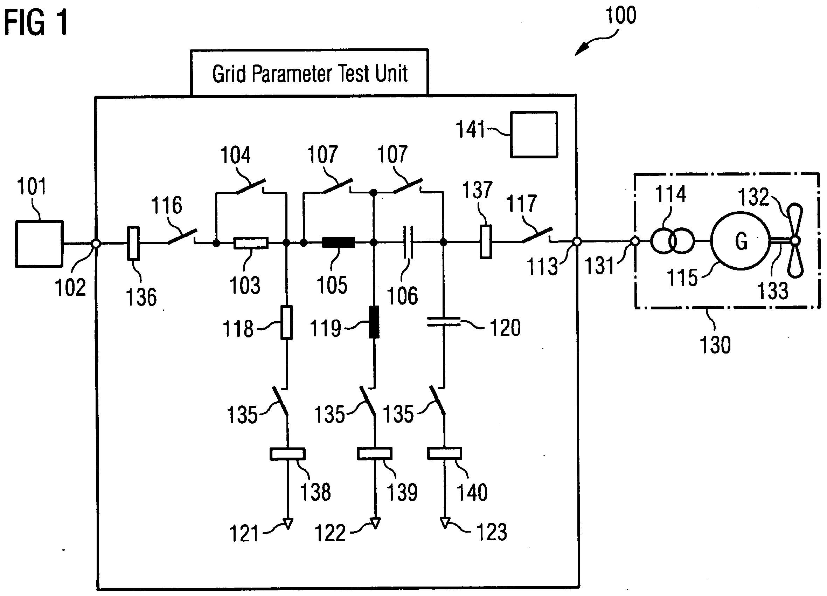

Document EP 1 796 259 A2 (GEN ELECTRIC, 13.06.2007) discloses a system and method of operating double-fed induction generators, wherein a protection system includes a plurality of controlled impedance devices, wherein each of the controlled impedance devices is coupled between a respective phase of a stator winding of the double-fed induction generator and a respective phase of a grid side converter, as is illustrated in Figure 1 and described in paragraph [0007].

Conventionally, an electric power generation system, such as a wind turbine system, is manufactured at a manufacturing site and is eventually installed at a production site remote from the manufacturing site for producing electric energy. At the production site the electric power generation system is supposed to be connected to an electrical utility grid. The utility grid at the final production site may be characterized by a number of electrical parameters which have to be met or need to be tolerated by the electric power generation system. Conventionally, it may be difficult to test the performance or the electric behaviour of the electric power generation system at the manufacturing site, since at the manufacturing site or at a test site remote from the production site only an auxiliary electrical grid or test electrical grid is available which does not exhibit the same or similar electrical parameters as the utility grid at the production site.

Thus, there may be a need for an arrangement and for a method for testing an electric power generation system, in particular a wind turbine system, which allow examining or testing the electric power generation system in particular in respect to a compatibility of the electric power generation system with the utility grid at the production site.

### Summary of the Invention

This need may be met by the subject matter according to the independent claims. Advantageous embodiments of the present invention are described by the dependent claims.

According to an embodiment an arrangement (in particular comprising a number of electric or electronic components including wire connection, switches, resistors, capacitors, inductors, transistors) for testing (monitoring a functionality or monitoring an electric behaviour under certain electrical conditions) an electric power generation system (in particular a system for generating electric power comprising an electro-mechanical device or apparatus for converting mechanical energy to electrical energy), in particular a wind turbine system (in particular comprising a wind turbine tower, a nacelle mounted at the top of the tower, and an electric generator coupled to a rotation shaft mounted within the nacelle, wherein at the rotation shaft one or more wind turbine blades are mounted, wherein the generator may also comprise a converter and/or a transformer), to be connected (or to be supposed to be connected) to an electrical utility grid (to which a number of consumers or loads may be connected, wherein the utility grid provides electric energy to the plurality of consumers or loads using electrical wire connections, switches, transformers and other electric or electronic elements) having a predetermined first electrical impedance (in particular characterizing a resistance comprising a real portion and comprising an imaginary portion, in particular describing a measure of opposition or resistance to an alternating current, wherein the electrical impedance may be represented by a complex number, wherein the magnitude of the complex number of the impedance is the ratio of the voltage amplitude to the current amplitude and wherein the phase of the complex number of the impedance is the phase-shift by which the current is ahead of the voltage, wherein the reciprocal of the impedance may also be referred to as admittance, wherein the complex impedance may be represented in a polar form or in a Cartesian form, wherein the real part of the Cartesian form is the resistance R and wherein the imaginary part of the Cartesian form of the impedance is the reactans X, wherein the impedance of the utility grid may be purely real, if the consumers and the loads connected to the utility grid are pure resistors and wherein the impedance of the utility grid may be purely imaginary, if the consumers or the loads connected to the utility grid are purely inductors and/or capacitors), wherein the arrangement comprises an input terminal (such as a connection point, a plug or a socket) for electrically connecting the arrangement to an output terminal (to which the power generation system supplies the generated electric energy) of the power generation system; a grid terminal (such as a connection point, a plug or a socket) for electrically connecting the arrangement to the utility grid; and an electrical adjustment system (in particular comprising one or more electrical or electronic components, such as a resistor, a capacitor, an inductor, a transistor, a switch and/or one or more wire portions) connected between the input terminal and the grid terminal (wherein this connection may be indirect, such that one or more other components may be between the adjustment system and the input terminal and such that one or more components may be in between the adjustment system and the grid terminal), wherein the adjustment system is adapted (in particular by the specific physical configuration and arrangement and connection manner of the components comprised in the adjustment system) to adjust (in particular to regulate, to modify, to adapt, to change or to simulate) an impedance at the input terminal to the predetermined first impedance, when an auxiliary grid (which is different from the utility grid and which may in particular be located at a manufacturing site or a test site of the electric power generation system) having a second impedance different from the first impedance is connected at the grid terminal.

In particular, the electrical adjustment system may be used to model a number of different utility grid parameters (utility grid impedances) so that it may be possible to perform measurements of the electric power generation system at the manufacturing site, to reflect the properties and conditions and electrical parameters the electric power generation system will be subjected to at the production site of the final installation. Thereby, it may be easier to predict, to measure or to observe the behaviour of the electric power generation system, when it is actually and finally connected to the utility grid at the production site. Thereby, problems or failures of the electric power generation system upon particular electric conditions or utility grid parameters may be identified and discovered already at the manufacturing site or the test site at which only the auxiliary grid is available. Thereby, testing an electric power generation system can more easily be performed and can be performed in a more flexible manner.

According to an embodiment the electrical adjustment system comprises (at least one) component selected from a capacitor, a resistor, an inductor and a switch. In particular, one or more components selected from the above group of components may be present, wherein the components may be connected to each other in series, in parallel, in a star configuration, in a delta configuration or in any combination of the above connection types. By providing this kind of component being a capacitor, a resistor, an inductor and/or a switch the impedance at the input terminal may be more easily be adapted to be the first impedance of the utility grid at the production site.

According to an embodiment the electrical adjustment system comprises a bypass switch connected in parallel to the component. Thereby, the component may selectively allow current flow through the component or may be bypassed via the bypass switch (when the bypass switch is closed) to have more flexibility for adjusting the impedance to be the predetermined first impedance. In particular, if more than one component is comprised within the electrical adjustment system each of these components may comprise a bypass switch to selectively bypass the component or allow current flow through the component.

According to an embodiment the component is connected to a reference point (such as a ground point or a particular phase). If the electrical adjustment system comprises one or more components a number of components may be connected to a same reference point. Thereby, discharging of a power signal to the reference point is enabled for extending the testing ability of the arrangement for testing the electrical power generation system.

According to an embodiment the adjustment system comprises a reference point switch via which the component is connected to the reference point. Thus, a current flow through the component towards the reference point may selectively be allowed or not allowed by switching the reference point switch. Thereby, an improved flexibility is provided for testing the electric power generation system.

According to an embodiment the adjustment system comprises at least one further component selected from a capacitor, a resistor, an inductor, and a switch.

According to an embodiment the at least one further component is connected in series with the component. If the at least one further component comprises even more components some of them may be connected in series with the components and in series relative to each other or may be connected at least partially to one or more reference points.

According to an embodiment the adjustment system comprises a further bypass switch connected in parallel to the at least one further component. Thereby, current flow through the further component may selectively be allowed or not allowed, thereby improving the flexibility of testing the electric power generation system and improving the flexibility of adjustment of the impedance.

According to an embodiment the at least one further component is connected to a further reference point (which may in particular be electrically connected to the reference point).

According to an embodiment the arrangement for testing the electric power generation system further comprises a current measurement system (comprising in particular any sensor or apparatus which is responsive to an electric current) for measuring an electric current at the input terminal (or at a wire leading to the input terminal) and/or at the grid terminal (or at a wire leading to or leading from the grid terminal). Thereby, it is enabled to measure an electric current within the arrangement for testing the electric power generation system or in a wire leading to or leading from the arrangement for testing the electric power generation system, in order to measure or monitor the behaviour of the electric power generation system when connected via the arrangement for testing the electric power generation system to the auxiliary grid. Thereby, it is enabled to determine whether the electric power generation system meets predetermined criteria regarding electric current values under particular electric parameters of the grid to which it is supposed to be connected. Thereby, problems of the electric power generation system may already be identified at the manufacturing site or test site which enables fast repair or correction of the problems.

According to an embodiment the arrangement for testing the electric power generation system further comprises a voltage measurement system (for measuring an electric voltage between two points) for measuring a voltage between a fixed potential point (such as a ground point) and the input terminal and/or for measuring a voltage between the fixed potential point and the grid terminal. Thereby, it is enabled to measure, to determine or to observe voltage values at a number of point pairs within the arrangement for testing the electric power generation system, in order to monitor or measure or to observe the behaviour of the electric power generation system under the simulated conditions of the electric utility grid. In case that the measured voltage values do not satisfy predetermined criteria the electric power generation system may be modified or repaired to remedy the problem.

According to an embodiment the arrangement for testing the electric power generation system further comprises a first coil (such as an inductor comprising a wound wire) at least temporarily connectable between the input terminal and a first coil reference point. In particular, the first coil may be connected between the input terminal and the first coil reference point during a short time period, such as during a time period between 1 µs and 100 ms, in particular between 1 ms and 10 ms, in order to monitor the behaviour of the electric power generation system upon an occurrence of a short duration low voltage event or low voltage ride through (LVRT). Thereby, a failure of the utility grid may be simulated to which the electric power generation system has to react in a particular manner to meet local criteria or local regulations. Thereby, testing the electric power generation system may further be improved and performed in a thorough manner.

According to an embodiment the arrangement for testing the electric power generation system further comprises a second coil (such as a wound wire) which is at least temporarily connectable (or constantly connected) between the input terminal and the grid terminal. In particular, the secondary may be connected between the input terminal and the grid terminal (in particular connected indirectly to the grid terminal, in particular via the further components of the test arrangement), when the first coil is connected between the input terminal and the first coil reference point, in order to limit the influence of the LVRT on the auxiliary grid. In particular, the first coil may have a parallelly connected bypass switch (connected in parallel) and the second coil may be connected via a switch to the first coil reference point.

According to an embodiment the second coil is connectable (or constantly connected) (in particular temporarily) between the input terminal and a mid node (or mid point) and the adjustment system is connected between the mid node and the grid terminal.

According to an embodiment a method for testing an electric power generation system is provided, in particular a wind turbine system, wherein the electric power generation system is supposed to be connected to an utility grid having a predetermined first impedance, wherein the method comprises connecting the arrangement via an input terminal to an output terminal of the power generation system; connecting the arrangement via a grid terminal to an auxiliary grid having a second impedance different from the first impedance; and adjusting, using an electrical adjustment system connected between the input terminal and the grid terminal, an impedance at the input terminal to the predetermined first impedance.

Any feature (individually or in any combination) disclosed, described, explained or mentioned with respect to an explanation of an embodiment of an arrangement for testing an electric power generation system may also (individually or in any combination) applied to, used for or employed for an embodiment of a method for testing an electric power generation system and vice versa.

The electric power generation system may provide two phases, three phases, or more phases of an electric power signal to be supplied to the utility grid which may also provide two connection points, three connection points or more connection points for feeding in the two phase, three phase or multiple-phase electrical power signal into the utility grid. In particular, the electric power signal may be an alternating power signal having a frequency between 50 Hz and 60 Hz. According to an embodiment the arrangement for testing the electric power generation system may be applied to every phase which is provided by the electric power generation system.

It has to be noted that embodiments of the invention have been described with reference to different subject matters. In particular, some embodiments have been described with reference to method type claims whereas other embodiments have been described with reference to apparatus type claims. However, a person skilled in the art will gather from the above and the following description that, unless other notified, in addition to any combination of features belonging to one type of subject matter also any combination between features relating to different subject matters, in particular between features of the method type claims and features of the apparatus type claims is considered as to be disclosed with this document.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

### Brief Description of the Drawings

Embodiments of the present invention are now described with reference to the accompanying drawings to which the invention is not restricted.
Fig. 1 schematically illustrates a circuit diagram of an arrangement for testing an electric power generation system according to an embodiment; and
Fig. 2 schematically illustrates a circuit diagram of another embodiment of an arrangement for testing an electric power generation system.

### Detailed Description

The illustration in the drawing is schematic. It is noted that in different figures, similar or identical elements are provided with the same reference signs or with reference signs, which are different from the corresponding reference signs only within the first digit.

Fig. 1 schematically illustrates a circuit diagram of an arrangement 100 for testing an electric power generation system 130. The arrangement 100 (also referred to as test arrangement) comprises an input terminal 113 for connecting the arrangement 100 to an output terminal 131 of the electric power generation system 130.

In the illustrated embodiment the electric power generation system 130 is a wind turbine system comprising a rotor 133 having mounted thereon rotor blades 132, wherein the rotor drives a generator 115 via the rotor shaft 133. The generator 115 generates electric energy which is supplied to a transformer 114 to transform the voltage of the energy power signal to an appropriate value at the output terminal 131.

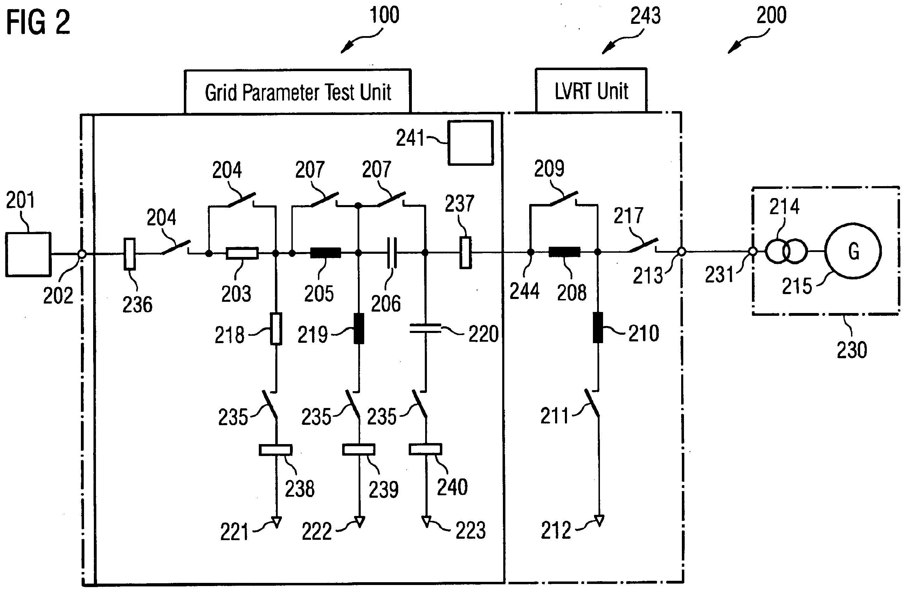

It should be noted that the circuit diagram illustrated in Fig. 1 and also that illustrated in Fig. 2 is depicted in an abstract way disregarding different phases of the energy signal supplied from the electric power generation system 130. Usually the electric power generation system 130 may provide two, three or even more phases of the power signal to two, three or more output terminals 131. It should be understood that these two, three or more output terminals 131 are then connected to two, three or more input terminals 113 of the test arrangement 100. Accordingly, the test arrangement 100 may have for each phase a corresponding plurality of interconnected electric components to perform the testing function.

The test arrangement 100 further comprises a grid terminal 102 for connecting the arrangement 100 to the utility grid 101. In particular, at the manufacturing site or test site an auxiliary electric grid may be connected to the grid terminal 102 allowing to test the behaviour and the functionality of the electric power generation system 130. After having tested the electric power generation system 130 it may be transported to the actual production site and may then be (in particular directly) connected to the utility grid at the production site. At the production site the test arrangement 100 may or may not be connected in between the electric power generation system 130 and the utility grid 101.

The test arrangement 100 comprises a switch 116, a variable or fixed resistor 103, a variable or fixed detuning coil or inductor 105, a variable or fixed capacitor 106 and an optionally main breaker switch 117 to disconnect the test arrangement 100 from the electric power generation system 130, wherein the components 116, 103, 105, 106 and 117 are connected in series between the grid terminal 102 and the input terminal 113.

In parallel to the variable or fixed resistor 103 a bypass main switch 104 for the resistor is arranged. In parallel to the variable or fixed detuning coil or inductor 105 for the capacitor a bypass switch 107 is arranged for bypassing the variable or fixed detuning coil 105. Similarly, parallel to the variable or fixed capacitor 106 a bypass main switch 107 for the capacitor 106 is provided for bypassing the capacitor 106.

A variable or fixed resistor 118 is connected to a point between the variable or fixed resistor 103 and the variable or fixed detuning coil 105 and the variable or fixed resistor 118 is connected via a switch 135 to a reference point 121 which may be changed by a switch or may be changed manually between phase (in star or delta) and/or to ground.

A variable or fixed coil or inductor 119 is connected to a point between the variable or fixed detuning coil 105 and the variable or fixed capacitor 106 and is connected via a switch 135 to the reference point 122 which may in particular be connected to the reference point 121.

A variable or fixed capacitor 120 is connected via the optionally main breaker switch 117 to the input terminal 113 and is connected via a switch 135 to a reference point 123 which may in particular be connected to the reference point 121.

An auxiliary grid 101 connected at the grid terminal 102 may have a second impedance which is different from a predetermined first impedance of the utility grid at the production site, where the electric power generation system 130 is supposed to be installed. By appropriate selection and design of the electrical parameters of the components 103, 105, 106, 118, 119, 120 and appropriate settings of the switches 116, 104, 107, 117, 135 the impedance at the input terminal 113 may be adjusted to the predetermined first impedance of the utility grid at the production site.

With the particular selection and design of the components comprised in the test arrangement 100 the electrical behaviour of the electric power generation system 130 may be measured using one or more current and/or voltage measurement systems 136, 137, 138, 139 and 140 to just illustrate placement of measurement systems at exemplary positions within the test arrangement 100. In other embodiments other measurement systems may be arranged at other positions of the circuit diagram of the test arrangement 100.

Further, a control system 141 is provided for controlling the setting of the switches 116, 104, 107, 117, 135 and the settings of the components having variable electrical properties, such as the components 103, 105, 106, 118, 119 or/and 120. Thereby, the control system 141 is adapted to adjust the impedance at the input terminal 113 to a desired (complex) value, in particular comprising a predetermined real part and a predetermined imaginary part. After setting the switches comprised in the test arrangement 100 and controlling the parameter values of the electric components within the test arrangement 100 current and/or voltage at different points within the test arrangement 100 is measured to determine, whether the electric power generation system 130 satisfies predetermined criteria or local regulations.

Fig. 2 schematically illustrates a circuit diagram of another embodiment of an arrangement for testing an electronic power generation system. As a subsystem the test arrangement 200 comprises a test system 100 as is illustrated in Fig. 1 which is also referred to as a grid parameter test unit.

Additionally, the arrangement 200 for testing the electric power generation system 230 comprises a low voltage ride through (LVRT) unit 243 which is connected between the input terminal 213 and the grid parameter test unit 100. The LVRT unit 243 is provided for simulating a voltage drop at the input terminal 213 for testing the behaviour of the electric power generation system 230 in response to the voltage drop.

For simulating the voltage (also referred to as low voltage ride through) the unit 243 comprises a short-cut variable or fixed impedance or inductor 210 which is connected via a short-cut main switch 211 to a short-cut reference point 212, which can be changed by a switch or manually between phase (in star or delta) and/or to ground.

In particular, the control system 241 may control (via not illustrated control lines) the short-cut main switch 211 to effect the voltage drop for a short time period by closing the switch 211. Further, the control system 241 may control also the switches 209, 217 and the electrical parameters of the variable or fixed series impedance or inductor 208 and the short-cut variable or fixed impedance or inductor 210. The variable or fixed series impedance or inductor 208 is connected between the input terminal 213 and the grid parameter test unit 100 for limiting the voltage drop towards the grid parameter test unit and limiting the voltage drop towards the grid 201. By including the low voltage ride through unit 243 into the test arrangement 200 testing the electric power generation system (in particular a wind turbine system) may be improved.

In particular local regulations may demand for generating units to test the behaviour of the electric power generation system during failures in the grid 101 or 201. According to an embodiment the electric power generation system 130 or 230 is tested at the manufacturing site or test site by subjecting it to the real utility grid parameters (grid impedance-resistance, inductivity and capacity) corresponding to the values at the production site. In particular, the test arrangements 100, 200 comprise one or more coils, one or more capacitors and/or resistances. Thereby, the coils may be used as short circuit and lengthwise impedances. The capacitors and/or resistances may be connected in series or in parallel to the lengthwise impedances or to the short-cut impedances in a delta or star connection. In this way it may be possible to vary all possible grid parameters (grid impedances) so that it may be possible to perform measurements at the same conditions as at the planned/existing generating plant site (also referred to as production site).

It should be noted that the term "comprising" does not exclude other elements or steps and "a" or "an" does not exclude a plurality. Also elements described in association with different embodiments may be combined. It should also be noted that reference signs in the claims should not be construed as limiting the scope of the claims.

## Claims

1. Arrangement for testing an electric power generation system which is connectable to a utility grid having a predetermined first impedance, the arrangement comprising:
an input terminal (113, 213) for connecting the arrangement to an output terminal (131, 231) of the power generation system (130, 230);
a grid terminal (102, 202) for connecting the arrangement to the utility grid (101, 201); and
an electrical adjustment system (100) connected between the input terminal and the grid terminal; wherein
the electrical adjustment system is adapted to adjust an impedance at the input terminal to the predetermined first impedance, when an auxiliary grid being different from the utility grid and having a second impedance different from the first impedance is connected at the grid terminal,
- the electrical adjustment system (100) comprises a series connection of series elements connected between the input terminal (113, 213) and the grid terminal (102, 202), wherein a first series element of the series elements comprises exalusively a capacitor (106, 206) and a first bypass switch (107, 207) connected in parallel to the capacitor (106, 206), and
wherein a second series element of the series elements comprises exclusively an inductor (105, 205) and a second bypass switch (107, 207) connected in parallel to the inductor (105, 205),
wherein a third series element of the series elements comprises exclusively a resistor (103, 203) and a third bypass switch (104, 204) connected in parallel to the resistor (103, 203); and
- the electrical adjustment system (100) further comprises a parallel connection of parallel elements connected between the series elements and reference points,
wherein a first parallel element of the parallel elements comprises exclusively a further capacitor (120, 220) and a first reference point switch (135, 235) connected in series to the further capacitor (120, 220) and the first parallel element is connected between the first series element and a first reference point (123, 223),
wherein a second parallel element of the parallel elements comprises exclusively a further inductor (119, 219) and a second reference point switch (135, 235) connected in series to the further inductor (119, 219) and the second parallel element is connected between the second series element and a second reference point (122, 222),
wherein a third parallel element of the parallel elements comprises exclusively a further resistor (118, 218) and a third reference point switch (135, 235) connected in series to the further resistor (118, 218) and the third parallel element is connected between the third series element and a third reference point (121, 221).

2. Arrangement according to the preceding claim, further comprising:
a current measurement system (136-140) for measuring a current at the input terminal and/or at the grid terminal.

3. Arrangement according to one of the preceding claims, further comprising:
a voltage measurement system (136-140) for measuring a voltage between a fixed potential point and the input terminal and/or for measuring a voltage between the fixed potential point and the grid terminal.

4. Arrangement according to one of the preceding claims, further comprising:
a first coil (210) at least temporarily connectable between the input terminal and a first coil reference point.

5. Arrangement according to one of the preceding claims, further comprising:
a second coil (208) at least temporarily connectable between the input terminal and the grid terminal.

6. Arrangement according to the preceding claim, wherein
the second coil is connectable between the input terminal and a mid node (244) and the electrical adjustment system (100) is connected between the mid node and the grid terminal.

7. Method for testing an electric power generation system to be connected to a utility grid having a predetermined first impedance, the method comprising:
connecting an arrangement via an input terminal (113,213) to an output terminal (131, 231) of the power generation system (130, 230);
connecting the arrangement via a grid terminal (102, 202) to an auxiliary grid (101, 201) being different from the utility grid and having a second impedance different from the first impedance; and
adjusting, using an electrical adjustment system connected between the input terminal and the grid terminal, an impedance at the input terminal to the predetermined first impedance; wherein
- the electrical adjustment system (100) comprises a series connection of series elements connected between the input terminal (113, 213) and the grid terminal (102, 202), wherein a first series element of the series elements comprises exclusively a capacitor (106, 206) and a first bypass switch (107, 207) connected in parallel to the capacitor (106, 206),
wherein a second series element of the series elements comprises exclusively an inductor (105, 205) and a second bypass switch (107, 207) connected in parallel to the inductor (105, 205),
wherein a third series element of the series elements comprises exclusively a resistor (103, 203) and a third bypass switch (104, 204) connected in parallel to the resistor (103, 203); and
- the electrical adjustment system (100) further comprises a parallel connection of parallel elements connected between the series elements and reference points,
wherein a first parallel element of the parallel elements comprises exclusively a further capacitor (120, 220) and a first reference point switch (135, 235) connected in series to the further capacitor (120, 220) and the first parallel element is connected between the first series element and a first reference point (123, 223),
wherein a second parallel element of the parallel elements comprises exclusively a further inductor (119, 219) and a second reference point switch (135, 235) connected in series to the further inductor (119, 229) and the second parallel element is connected between the second series element and a second reference point (122, 222),
wherein a third parallel element of the parallel elements comprises exclusively a further resistor (118, 218) and a third reference point switch (135, 235) connected in series to the further resistor (118, 218) and the third parallel element is connected between the third series element and a third reference point (121, 221).

## Patentansprüche

1. Anordnung zum Prüfen eines Stromerzeugungssystems, welches an ein Versorgungsnetz mit einer vorbestimmten ersten Impedanz anschließbar ist, wobei die Anordnung umfasst:
eine Eingangsklemme (113, 213) zum Anschließen der Anordnung an eine Ausgangsklemme (131, 231) des Stromerzeugungssystems (130, 230);
eine Netzanschlussklemme (102, 202) zum Anschließen der Anordnung an das Versorgungsnetz (101, 201); und
ein elektrisches Einstellsystem (100), das zwischen die Eingangsklemme und die Netzanschlussklemme geschaltet ist;
wobei
das elektrische Einstellsystem dazu eingerichtet ist, eine Impedanz an der Eingangsklemme auf die vorbestimmte erste Impedanz einzustellen, wenn ein Hilfsnetz, das von dem Versorgungsnetz verschieden ist und eine zweite Impedanz aufweist, die von der ersten Impedanz verschieden ist, an die Netzanschlussklemme angeschlossen wird,
- das elektrische Einstellsystem (100) eine Reihenschaltung von Reihenelementen umfasst, die zwischen die Eingangsklemme (113, 213) und die Netzanschlussklemme (102, 202) geschaltet sind,
wobei ein erstes Reihenelement der Reihenelemente ausschließlich einen Kondensator (106, 206) und einen ersten Umgehungsschalter (107, 207), der zu dem Kondensator (106, 206) parallelgeschaltet ist, umfasst, und
wobei ein zweites Reihenelement der Reihenelemente ausschließlich eine Induktionsspule (105, 205) und einen zweiten Umgehungsschalter (107, 207), der zu der Induktionsspule (105, 205) parallelgeschaltet ist, umfasst, wobei ein drittes Reihenelement der Reihenelemente ausschließlich einen Widerstand (103, 203) und einen dritten Umgehungsschalter (104, 204), der zu dem Widerstand (103, 203) parallelgeschaltet ist, umfasst; und
- das elektrische Einstellsystem (100) ferner eine Parallelschaltung von parallelen Elementen umfasst, die zwischen die Reihenelemente und Referenzpunkte geschaltet sind,
wobei ein erstes paralleles Element der parallelen Elemente ausschließlich einen weiteren Kondensator (120, 220) und einen ersten Referenzpunktschalter (135, 235), der zu dem weiteren Kondensator (120, 220) in Reihe geschaltet ist, umfasst, und das erste parallele Element zwischen das erste Reihenelement und einen ersten Referenzpunkt (123, 223) geschaltet ist, wobei ein zweites paralleles Element der parallelen Elemente ausschließlich eine weitere Induktionsspule (119, 219) und einen zweiten Referenzpunktschalter (135, 235), der zu der weiteren Induktionsspule (119, 219) in Reihe geschaltet ist, umfasst, und das zweite parallele Element zwischen das zweite Reihenelement und einen zweiten Referenzpunkt (122, 222) geschaltet ist,
wobei ein drittes paralleles Element der parallelen Elemente ausschließlich einen weiteren Widerstand (118, 218) und einen dritten Referenzpunktschalter (135, 235), der zu dem weiteren Widerstand (118, 218) in Reihe geschaltet ist, umfasst, und das dritte parallele Element zwischen das dritte Reihenelement und einen dritten Referenzpunkt (121, 221) geschaltet ist.

2. Anordnung nach dem vorhergehenden Anspruch, welche ferner umfasst:
ein Strommesssystem (136-140) zum Messen eines Stroms an der Eingangsklemme und/oder an der Netzanschlussklemme.

3. Anordnung nach einem der vorhergehenden Ansprüche, welche ferner umfasst:
ein Spannungsmesssystem (136-140) zum Messen einer Spannung zwischen einem Punkt mit festem Potential und der Eingangsklemme und/oder zum Messen einer Spannung zwischen dem Punkt mit festem Potential und der Netzanschlussklemme.

4. Anordnung nach einem der vorhergehenden Ansprüche, welche ferner umfasst:
eine erste Spule (210), die zumindest zeitweilig zwischen die Eingangsklemme und einen ersten Spulenreferenzpunkt schaltbar ist.

5. Anordnung nach einem der vorhergehenden Ansprüche, welche ferner umfasst:
eine zweite Spule (208), die zumindest zeitweilig zwischen die Eingangsklemme und die Netzanschlussklemme schaltbar ist.

6. Anordnung nach dem vorhergehenden Anspruch, wobei die zweite Spule zwischen die Eingangsklemme und einen mittleren Knoten (244) schaltbar ist und das elektrische Einstellsystem (100) zwischen den mittleren Knoten und die Netzanschlussklemme geschaltet ist.

7. Verfahren zum Prüfen eines Stromerzeugungssystems, welches an ein Versorgungsnetz mit einer vorbestimmten ersten Impedanz angeschlossen werden soll, wobei das Verfahren umfasst:
Anschließen einer Anordnung über eine Eingangsklemme (113, 213) an eine Ausgangsklemme (131, 231) des Stromerzeugungssystems (130, 230);
Anschließen der Anordnung über eine Netzanschlussklemme (102, 202) an ein Hilfsnetz (101, 201), das von dem Versorgungsnetz verschieden ist und eine zweite Impedanz aufweist, die von der ersten Impedanz verschieden ist; und
Einstellen, unter Verwendung eines elektrischen Einstellsystems, das zwischen die Eingangsklemme und die Netzanschlussklemme geschaltet ist, einer Impedanz an der Eingangsklemme auf die vorbestimmte erste Impedanz; wobei
- das elektrische Einstellsystem (100) eine Reihenschaltung von Reihenelementen umfasst, die zwischen die Eingangsklemme (113, 213) und die Netzanschlussklemme (102, 202) geschaltet sind,
wobei ein erstes Reihenelement der Reihenelemente ausschließlich einen Kondensator (106, 206) und einen ersten Umgehungsschalter (107, 207), der zu dem Kondensator (106, 206) parallelgeschaltet ist, umfasst,
wobei ein zweites Reihenelement der Reihenelemente ausschließlich eine Induktionsspule (105, 205) und einen zweiten Umgehungsschalter (107, 207), der zu der Induktionsspule (105, 205) parallelgeschaltet ist, umfasst, wobei ein drittes Reihenelement der Reihenelemente ausschließlich einen Widerstand (103, 203) und einen dritten Umgehungsschalter (104, 204), der zu dem Widerstand (103, 203) parallelgeschaltet ist, umfasst; und
- das elektrische Einstellsystem (100) ferner eine Parallelschaltung von parallelen Elementen umfasst, die zwischen die Reihenelemente und Referenzpunkte geschaltet sind,
wobei ein erstes paralleles Element der parallelen Elemente ausschließlich einen weiteren Kondensator (120, 220) und einen ersten Referenzpunktschalter (135, 235), der zu dem weiteren Kondensator (120, 220) in Reihe geschaltet ist, umfasst, und das erste parallele Element zwischen das erste Reihenelement und einen ersten Referenzpunkt (123, 223) geschaltet ist, wobei ein zweites paralleles Element der parallelen Elemente ausschließlich eine weitere Induktionsspule (119, 219) und einen zweiten Referenzpunktschalter (135, 235), der zu der weiteren Induktionsspule (119, 219) in Reihe geschaltet ist, umfasst, und das zweite parallele Element zwischen das zweite Reihenelement und einen zweiten Referenzpunkt (122, 222) geschaltet ist,
wobei ein drittes paralleles Element der parallelen Elemente ausschließlich einen weiteren Widerstand (118, 218) und einen dritten Referenzpunktschalter (135, 235), der zu dem weiteren Widerstand (118, 218) in Reihe geschaltet ist, umfasst, und das dritte parallele Element zwischen das dritte Reihenelement und einen dritten Referenzpunkt (121, 221) geschaltet ist.

## Revendications

1. Un agencement destiné à tester un système de génération de courant électrique qui peut être raccordé à un réseau de distribution public possédant une première impédance prédéterminée, l'agencement comprenant :
une borne d'entrée (113, 213) destinée à raccorder l'agencement à une borne de sortie (131, 231) du système de génération d'électricité (130, 230),
une borne de réseau de distribution (102, 202) destinée à raccorder l'agencement au réseau de distribution public (101, 201), et
un système de réglage électrique (100) raccordé entre la borne d'entrée et la borne de réseau de distribution, dans lequel le système de réglage électrique est adapté de façon à régler une impédance au niveau de la borne d'entrée sur la première impédance prédéterminée lorsqu'un réseau de distribution auxiliaire qui est différent du réseau de distribution public et qui possède une deuxième impédance différente de la première impédance est raccordé au niveau de la borne de réseau de distribution,
- le système de réglage électrique (100) comprend un raccordement série d'éléments série raccordés entre la borne d'entrée (113, 213) et la borne de réseau de distribution (102, 202), dans lequel un premier élément série des éléments série comprenant exclusivement un condensateur (106, 206) et un premier commutateur de dérivation (107, 207) raccordé en parallèle au condensateur (106, 206), et
dans lequel un deuxième élément série des éléments série comprend exclusivement un inducteur (105, 205) et un deuxième commutateur de dérivation (107, 207) raccordé en parallèle à l'inducteur (105, 205),
dans lequel un troisième élément série des éléments série comprend exclusivement une résistance (103, 203) et un troisième commutateur de dérivation (104, 204) raccordé en parallèle à la résistance (103, 203), et
- le système de réglage électrique (100) comprend en outre un raccordement parallèle d'éléments parallèles raccordés entre les éléments série et des points de référence,
dans lequel un premier élément parallèle des éléments parallèles comprend exclusivement un autre condensateur (120, 220) et un premier commutateur de point de référence (135, 235) raccordé en série à l'autre condensateur (120, 220) et le premier élément parallèle est raccordé entre le premier élément série et un premier point de référence (123, 223),
dans lequel un deuxième élément parallèle des éléments parallèles comprend exclusivement un autre inducteur (119, 219) et un deuxième commutateur de point de référence (135, 235) raccordé en série à l'autre inducteur (119, 219) et le deuxième élément parallèle est raccordé entre le deuxième élément série et un deuxième point de référence (122, 222), dans lequel un troisième élément parallèle des éléments parallèles comprend exclusivement une autre résistance (118, 218) et un troisième commutateur de point de référence (135, 235) raccordé en série à l'autre résistance (118, 218) et le troisième élément parallèle est raccordé entre le troisième élément série et un troisième point de référence (121, 221).

2. L'agencement selon la revendication précédente, comprenant en outre :
un système de mesure de courant (136-140) destiné à mesurer un courant au niveau de la borne d'entrée et/ou au niveau de la borne de réseau de distribution.

3. L'agencement selon l'une quelconque des revendications précédentes, comprenant en outre :
un système de mesure de tension (136-140) destiné à mesurer une tension entre un point de potentiel fixe et la borne d'entrée et/ou destiné à mesurer une tension entre le point de potentiel fixe et la borne de réseau de distribution.

4. L'agencement selon l'une quelconque des revendications précédentes, comprenant en outre :
une première bobine (210) pouvant être raccordée au moins temporairement entre la borne d'entrée et un premier point de référence de bobine.

5. L'agencement selon l'une quelconque des revendications précédentes, comprenant en outre :
une deuxième bobine (208) pouvant être raccordée au moins temporairement entre la borne d'entrée et la borne de réseau de distribution.

6. L'agencement selon la revendication précédente, dans lequel la deuxième bobine peut être raccordée entre la borne d'entrée et un noeud médian (244) et le système de réglage électrique (100) est raccordé entre le noeud médian et la borne de réseau de distribution.

7. Un procédé de test d'un système de génération de courant électrique destiné à être raccordé à un réseau de distribution public possédant une première impédance prédéterminée, le procédé comprenant :
le raccordement d'un agencement par l'intermédiaire d'une borne d'entrée (113, 213) à une borne de sortie (131, 231) du système de génération d'électricité (130, 230),
le raccordement de l'agencement par l'intermédiaire d'une borne de réseau de distribution (102, 202) à un réseau de distribution auxiliaire (101, 201) qui est différent du réseau de distribution public et qui possède une deuxième impédance différente de la première impédance, et
le réglage, au moyen d'un système de réglage électrique raccordé entre la borne d'entrée et la borne de réseau de distribution, d'une impédance au niveau de la borne d'entrée sur la première impédance prédéterminée, dans lequel
- le système de réglage électrique (100) comprend un raccordement série d'éléments série raccordés entre la borne d'entrée (113, 213) et la borne de réseau de distribution (102, 202),
dans lequel un premier élément série des éléments série comprend exclusivement un condensateur (106, 206) et un premier commutateur de dérivation (107, 207) raccordé en parallèle au condensateur (106, 206),
dans lequel un deuxième élément série des éléments série comprend exclusivement un inducteur (105, 205) et un deuxième commutateur de dérivation (107, 207) raccordé en parallèle à l'inducteur (105, 205),
dans lequel un troisième élément série des éléments série comprend exclusivement une résistance (103, 203) et un troisième commutateur de dérivation (104, 204) raccordé en parallèle à la résistance (103, 203), et
- le système de réglage électrique (100) comprend en outre un raccordement parallèle d'éléments parallèles raccordés entre les éléments série et des points de référence,
dans lequel un premier élément parallèle des éléments parallèles comprend exclusivement un autre condensateur (120, 220) et un premier commutateur de point de référence (135, 235) raccordé en série à l'autre condensateur (120, 220) et le premier élément parallèle est raccordé entre le premier élément série et un premier point de référence (123, 223),
dans lequel un deuxième élément parallèle des éléments parallèles comprend exclusivement un autre inducteur (119, 219) et un deuxième commutateur de point de référence (135, 235) raccordé en série à l'autre inducteur (119, 219) et le deuxième élément parallèle est raccordé entre le deuxième élément série et un deuxième point de référence (122, 222), dans lequel un troisième élément parallèle des éléments parallèles comprend exclusivement une autre résistance (118, 218) et un troisième commutateur de point de référence (135, 235) raccordé en série à l'autre résistance (118, 218) et le troisième élément parallèle est raccordé entre le troisième élément série et un troisième point de référence (121, 221).
